(19) Europäisches Patentamt
European Patent Office
Office européen des brevets

(11) **EP 1 672 862 B1**

(12) **EUROPÄISCHE PATENTSCHRIFT**

(45) Veröffentlichungstag und Bekanntmachung des Hinweises auf die Patenterteilung:
**12.05.2010  Patentblatt 2010/19**

(51) Int Cl.:
*H04L 27/36* (2006.01)          *H04L 25/49* (2006.01)
*H03C 3/09* (2006.01)

(21) Anmeldenummer: **05027673.2**

(22) Anmeldetag: **16.12.2005**

(54) **Polarmodulator und Verfahren zur Modulation eines Signals**

Polar modulator and method for modulating of a signal

Modulateur polaire et procédé de modulation

(84) Benannte Vertragsstaaten:
**DE FR GB**

(30) Priorität: **16.12.2004   DE 102004060698**

(43) Veröffentlichungstag der Anmeldung:
**21.06.2006   Patentblatt 2006/25**

(73) Patentinhaber: **Infineon Technologies AG**
**85579 Neubiberg (DE)**

(72) Erfinder: **Li Puma, Giuseppe**
**44791 Bochum (DE)**

(74) Vertreter: **Viering, Jentschura & Partner**
**Postfach 22 14 43**
**80504 München (DE)**

(56) Entgegenhaltungen:
**EP-A- 0 998 088     US-A- 2003 112 063**

**Beschreibung**

Die Erfindung betrifft einen Polarmodulator sowie ein Verfahren zur Modulation eines Signals gemäß den Oberbegriffen der unabhängigen Patentansprüche.

Derartige Polarmodulatoren sind beispielsweise aus der US 2003/0112063 A1 bekannt. Auch die EP 0998088 A2 zeigt einen Polarmodulator und Verfahren zur Modulation eines Signals.

In modernen Kommunikationssystemen werden die zu übertragenden Informationen sowohl in der Phase als auch in der Amplitude eines Signals kodiert. Dadurch ist es möglich, im Gegensatz zu einer reinen Amplituden- beziehungsweise Phasenmodulation deutlich größere Datenübertragungsraten zu erreichen. Beispiele für derartige Modulationsarten sind die PSK-Modulationen (Phase-Shift-Keying). Dazu gehören unter anderem die π/4-DQPSK-, 8-DPSK- oder 8-PSK-Modulation. Auch Quadraturamplitudenmodulationen (QAM) kodieren die zu übertragenden Informationen sowohl in der Amplitude als auch in der Phase. Im Gegensatz zu der analogen Amplituden- oder Frequenzmodulation werden die genannten Modulationen als digitale Modulationsarten bezeichnet.

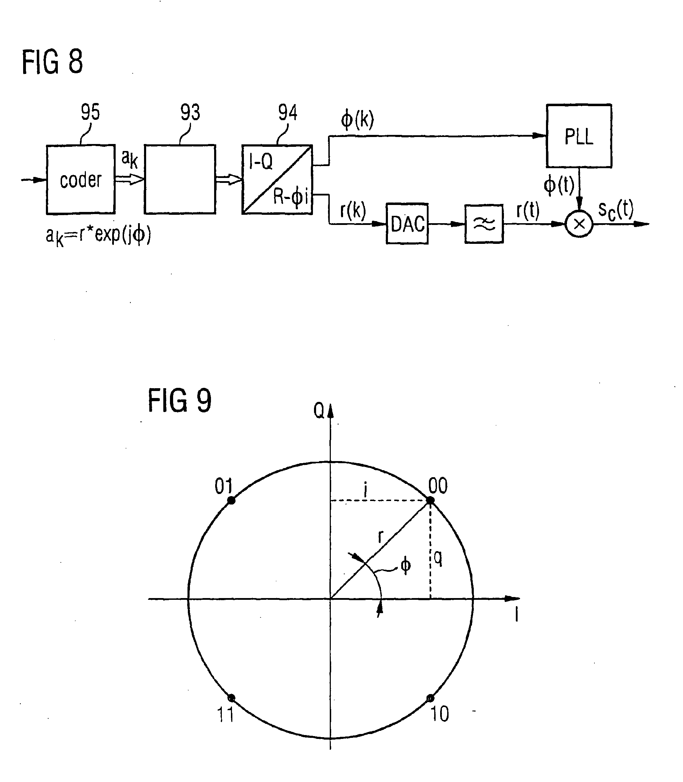

Figur 9 zeigt ein sogenanntes Konstellationsdiagramm für eine QPSK-Modulation. Die Abszisse stellt dabei eine erste Komponente dar, die als reelle Komponente I bezeichnet wird. Die Ordinate bildet die zweite, die Quadraturkomponente Q. Die zu übertragenden Informationen werden abhängig von ihrem Inhalt in einem der dargestellten Punkte durch ein Wertepaar i, q kodiert. Ein solches Wertepaar i, q wird als Symbol bezeichnet. Im dargestellten Ausführungsbeispiel kodiert ein solches Symbol bei der verwendeten QPSK-Modulationsart insgesamt zwei Bits Dateninhalt, nämlich die Bits 00, 01, 10 oder 11. Je nach den zu übertragenden Informationen ändern sich die Amplituden der i- und q-Werte über die Zeit. Dadurch wird auch die Amplitude des Gesamtsignals verändert. Man spricht somit bei einer QPSK-Modulation von einer Modulationsart mit einer nichtkonstanten Einhüllenden (Non-Constant-Envelope-Modulation). Die QPSK-Modulationsart wird beispielsweise für den Mobilfunkstandard WCDMA/UMTS verwendet. Der Mobilfunkstandard EDGE verwendet eine 8-PSK Modulation und kodiert somit 3 Bits pro Symbol.

Neben der Darstellung eines Symbols durch ein Wertepaar i, q ist es möglich, das gleiche Symbol in seiner Phase φ und seiner Amplitude r anzugeben. Im Ausführungsbeispiel der Figur 9 ist das Symbol, das den Dateninhalt 00 repräsentiert entsprechend dargestellt. Beide Darstellungen in IQ-Schreibweise beziehungsweise rφ-Schreibweise sind gleichbedeutend.

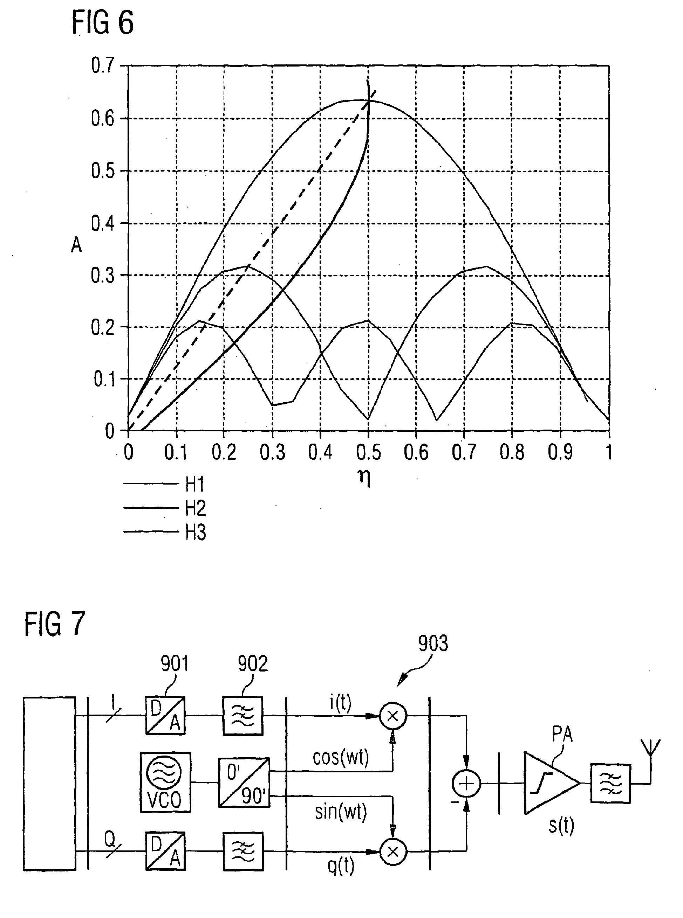

Zur Übertragung von modulierten Signalen lassen sich neben I/Q-Modulatoren auch Polarmodulatoren verwenden. Während I/Q-Modulatoren für eine Modulation eines Signals die i, q-Wertepaare verarbeiten, modulieren Polarmodulatoren die Phase φ auf ein Trägersignal und verändern die Amplitude r. Eine Ausführung für einen bekannten I/Q-Modulator ist in Figur 7 zu sehen. Darin werden die Komponenten I, Q als digitale Signale jeweils einem Digital/ Analogwandler 901 zugeführt, der sie in analoge Komponenten wandelt und sie über einen Tiefpassfilter 902 den Eingängen zweier Mischer 903 zuführt. Als Lokaloszillatorsignal werden den beiden Mischern Signale zugeführt, die zueinander einen Phasenversatz von 90 Grad aufweisen. Nach der Frequenzumsetzung in den beiden Mischern erfolgt eine Addition der beiden Signale und eine Verstärkung in einem Leistungsverstärker PA.

Ein Beispiel für einen bekannten Polarmodulator zeigt Figur 8. Die zu übertragenden Informationen liegen als digitale Daten vor und werden in einer Koderschaltung 95 in die Amplitudeninformation r und die Phaseninformation φ aufbereitet. Sie liegen als Symbolwerte $a_k$ vor, wobei $a_k$ sowohl die Amplitudeinformation r, als auch die Phaseinformation φ beinhaltet. Die Symbolwerte $a_k$ werden einer Pulsformerschaltung 93 zugeführt und dort aufbereitet. Die aufbereiteten Daten werden dann in der Schaltung 94 in ihren Phasenwert φ(k) sowie in einen Amplitudenwert r(k) umgewandelt. Die Phaseninformation φ(k) wird einem Phasenregelkreis PLL zugeführt. Sie wird dazu verwendet, das Ausgangssignal des Phasenregelkreises entsprechend der in der Phase kodierten Information zu modulieren. Am Ausgang des Regelkreises PLL liegt somit ein phasenmoduliertes Ausgangssignal φ(t) vor. Gleichzeitig wird die Amplitudeninformation r(k) an einen Digital/Analogwandler DAC angelegt, der die digitale Amplitudeninformation r(k) in ein zeitliches analoges Signal r(t) wandelt. Das analoge Amplitudenmodulationssignal r(t) wird über einen Tiefpassfilter einem Mischer zugeführt. In diesem wird das phasenmodulierte Signal mit dem Amplitudenmodulationssignal zusammengeführt. Der Mischer führt mit dem Amplitudenmodulationssignal r(t) eine Amplitudenmodulation des bereits phasenmodulierten Signals durch.

Problematisch bei dieser Lösung sind die Anforderungen an die letzte Mischerstufe. Diese sollte ein ausreichend gutes lineares Übertragungsverhalten aufweisen, um innerhalb des in vielen Mobilfunkstandards geforderten großen Amplitudenbereichs eine ausreichende Signalqualität einzuhalten. Bei einem nichtlinearen Übertragungsverhalten des Mischers können Amplituden- oder Phasenverzerrungen auftreten, die von dem Amplitudenmodulationssignal r(t) abhängig sind. Man bezeichnet derartige Verzerrungen als AM/AM- oder AM/PM-Verzerrung.

Die Verzerrung erzeugt Datenfehler und das Frequenzspektrum des abgegebenen Signals ändert sich dadurch.

Bei Berücksichtigung der Anforderungen führt die in Figur 8 dargestellte Ausführungsform zu einem hohen Platzbedarf für den Mischer. Darüber hinaus lässt sich ein derartiger Polarmodulator nicht in neuartigen CMOS-Technologien mit niedrigen Versorgungsspannungen im Bereich von 1,5 V bis 2,5 V implementieren.

Aufgabe der vorliegenden Erfindung ist es, einen Polarmodulator vorzusehen, der für niedrige Versorgungsspannungen geeignet und platzsparend bevorzugt als integrierte Schaltung in einem Halbleiterkörper realisierbar ist.

Eine weitere Aufgabe der Erfindung ist es, ein Verfahren zur Modulation eines Signals anzugeben, das mit einem geringen Stromverbrauch zu realisieren ist.

Diese Aufgaben werden mit den Gegenständen der nebengeordneten Patentansprüche 1 und 16 gelöst.

Bezüglich der Anordnung wird die Aufgabe gelöst durch einen Polarmodulator, umfassend:

- einen ersten Signaleingang zur Zuführung eines Phasenmodulationssignals und einen zweiten Signaleingang zur Zuführung eines Amplitudenmodulationssignals;
- einen Phasenregelkreis mit einem Referenzeingang zur Zuführung eines Referenzsignals und mit einem Stelleingang, der mit dem ersten Signaleingang gekoppelt ist, der Phasenregelkreis weiterhin ausgebildet zur Abgabe eines Hochfrequenzsignals mit einer Frequenz an einen Ausgang, wobei die Frequenz aus dem Referenzsignal und dem Phasenmodulationssignal am Stelleingang des Phasenregelkreises abgeleitet ist;
- einen Pulsweitenmodulator mit einem Signaleingang und mit Stelleingang, der Pulsweitenmodulator ausgebildet zu einer über ein Regelsignal am Stelleingang.einstellbaren Veränderung eines Tastverhältnisses eines am Signaleingang anliegenden Signals;
- ein einem Ausgang des Pulsweitenmodulators nachgeschaltetes Filter zur Unterdrückung harmonischer Anteile eines am Ausgang des Pulsweitenmodulators abgreifbaren Signals;

wobei der Signaleingang des Pulsweitenmodulators mit einem Ausgang des Phasenregelkreises zur Zuführung des vom Phasenregelkreis phasenmodulierten und pulsförmigen Hochfrequenzsignals und der Stelleingang mit dem zweiten Signaleingang gekoppelt ist;

wobei dem ersten Signaleingang eine Anpassschaltung nachgeschaltet ist, die einen mit dem zweiten Signaleingang gekoppelten Regeleingang umfasst und ausgeführt ist, abhängig von einem Signal am Regeleingang das dem ersten Signaleingang zugeführte Phasenmodulationssignal zu verändern.

Mit dieser Anordnung wird eine Amplitudenmodulation gemäß einem zugeführten Amplitudenmodulationssignals dadurch erreicht, dass das durch den Phasenregelkreis phasenmodulierte Signal einem Pulsweitenmodulator zugeführt wird. Dieser erzeugt ein zeitlich verändertes pulsweitenmoduliertes Signal, das in einem Filter zur Unterdrückung harmonischer Anteile weiterverarbeitet wird.

Dabei wird in der Erfindung ausgenutzt, dass rechtecksförmige Signale mit einem bestimmten Tastverhältnis durch eine Fourierreihenentwicklung sinusförmiger Signale darstellbar sind. Die Amplitude der Grundwelle der Reihenentwicklung hängt dabei von dem Tastverhältnis des Rechtecksignals ab. Durch geeignete Wahl des Tastverhältnisses mithilfe eines Pulsweitenmodulators wird so unter anderem eine Grundwelle der Fourierreihe mit der gewünschten Amplitude erzeugt. Am Ausgang eines dem Pulsweitenmodulator nachgeschalteten Filters wird dann nur noch die Grundwelle abgegeben. Höhere in der Reihenentwicklung vorkommende Frequenzanteile werden durch das nachgeschaltete Filter geeignet unterdrückt.

Die dargestellte Lösung ist vorteilhaft mit digitalen Schaltkreisen realisierbar. Insbesondere wird in einer vorteilhaften Weiterbildung der Phasenregelkreis 2 als digitaler Phasenregelkreis ausgeführt. Auch das Amplituden- beziehungsweise Phasenmodulationssignal liegt in einer vorteilhaften Ausführungsform als digitales Signal vor.

In einer Weiterbildung der Erfindung ist zwischen dem Ausgang des Phasenregelkreises und dem Signaleingang des Pulsweitenmodulators eine Verstärkerschaltung vorgesehen. Diese weist ein begrenztes Verstärkungsverhalten auf.

In einer Ausführungsform des Pulsweitenmodulators umfasst dieser einen Flip-Flop, dessen Takteingang den Signalausgang des Pulsweitenmodulators bildet. Ein Datenausgang des Flip-Flop ist an den Ausgang des pulsweiten Modulators angeschlossen. Einem Rücksetzeingang des Flip-Flops ist ein von dem am Stelleingang anliegenden Regelsignal abgeleitetes Pulssignal zuführbar. In dieser Ausgestaltung wird die Pulsweite eines am Takteingang des Flip-Flops anliegendes Signal gemäß den Pulssignalen moduliert. In diesem Zusammenhang ist es zweckmäßig, einem Dateneingang des Flip-Flops ein Signal mit gleichem Pegel zuzuführen.

In einer alternativen Ausgestaltungsform des Pulsweitenmodulators umfasst dieser ein logisches Gatter, dessen erster Eingang den Signaleingang des Pulsweitenmodulators bildet. Der Datenausgang des logischen Gatters ist an den Ausgang des Pulsweitenmodulators angeschlossen. Einem zweiten Eingang des logischen Gatters ist ein von dem am Stelleingang anliegenden Signal abgeleitetes Pulssignal zuführbar. Bevorzugt ist das logische Gatter als ein logisches UND-Gatter ausgebildet. Auch in diesem Fall wird das am ersten Eingang anliegende und vom Phasenregelkreis abgegebene phasenmodulierte Signal in seiner Pulsweite verändert.

Es ist zweckmäßig, wenn der Pulsweitenmodulator eine Verzögerungseinheit umfasst, die zu einer zeitlich steuerbaren Abgabe an eines Pulssignals an einen Ausgang ausgeführt ist. Der Ausgang ist dabei mit dem logischen Gatter oder dem Flip-Flop verbunden.

In einer anderen Weiterbildung der Erfindung enthält der Phasenregelkreis in einem Rückführungspfad einen Frequenzteiler mit einem einstellbaren Teilerverhältnis. Einem Einstelleingang dieses Frequenzteilers ist ein von dem Phasenmodulationssignal abgeleitetes Einstellsignal zuführbar.

Bevorzugt ist dem Einstelleingang des Frequenzteilers ein Sigma-Delta-Modulator vorgeschaltet. Dieser ist zur Erzeugung und Abgabe eines Stellsignals ausgeführt, das ein rationales Teilerverhältnis darstellt. Das Teilerverhältnis wird aus dem Phasenmodulationssignal am ersten Signaleingang des erfindungsgemäßen Polarmodulators erzeugt.

In einer Weiterbildung der Erfindung ist auch dem Stelleingang des Pulsweitenmodulators ein Sigma-Delta-Modulator vorgeschaltet. Mit Vorteil werden dessen Ausgangwerte mit Hilfe einer Synchronisationseinheit mit dem Trägersignal, eventuell auch dem vom Phasenregelkreis abgegebenen Signal einsynchronisiert. In einer Ausbildung der Erfindung wird hierzu das Trägersignal in seiner Frequenz heruntergeteilt, beispielsweise um den Faktor 2 und einem Takteingang einer Flip-Flop-Schaltung zugeführt.

Bevorzugt erzeugt dieser aus dem Amplitudenmodulationssignal ein überabgetastetes Regelsignal zur Einstellung des Tastverhältnisses im Pulsweitenmodulator. Dadurch kann das Quantisierungsrauschen reduziert und eine fehlerhafte Datenübertragung verhindert werden.

In einer bevorzugten Ausführungsform ist zwischen dem Regeleingang des Pulsweitenmodulators und dem zweiten Signaleingang zur Zuführung eines Amplitudenmodulationssignals eine Vorverzerrungseinheit geschaltet. Diese umfasst in einer bevorzugten Ausführungsform eine Tabelle, in der Werte abgelegt sind, welche eine Umkehrfunktion einer trigonometrischen Funktion, bevorzugt einen Sinus oder eine Cosinusfunktion, darstellen. Durch die Vorverzerrungseinheit wird eine Nichtlinearität durch die Signalverarbeitung des Pulsweitenmodulators verhindert. In diesem Zusammenhang ist es ebenso zweckmäßig, eine Phasenkompensationseinheit vorzusehen, die zwischen dem ersten Signaleingang des Polarmodulators und dem Stelleingang des Phasenregelkreises angeordnet ist. Sie weist einen Steuer- und Regeleingang auf, der mit dem Regeleingang des Pulsweitenmodulators gekoppelt ist. Dadurch wird eine Amplituden/Phasenverzerrung aufgrund der Verarbeitung des phasenmodulierten Signals im Pulsweitenmodulator kompensiert.

Bezüglich des Verfahrens wird die Aufgabe gelöst durch ein Verfahren mit den Schritten:

- Bereitstellen eines Phasenregelkreises mit einem einstellbaren Frequenzteilerverhältnis in einem Rückführungspfad des Phasenregelkreises;
- Bereitstellen einer Phaseninformation und einer Amplitudeninformation für eine Signalmodulation;
- Zuführen der Phaseninformation an den Phasenregelkreis und Einstellen des Frequenzteilerverhältnisses in Abhängigkeit der Phaseninformation;
- Erzeugen eines phasenmodulierten pulsförmigen Hochfrequenzsignals in Abhängigkeit des eingestellten Frequenzteilerverhältnisses;
- Verändern der Pulsweite des phasenmodulierten pulsförmigen Signals in Abhängigkeit der Amplitudeninformation;
- Filtern des Signals zur Unterdrückung von harmonischen Signalanteilen höherer Ordnung im veränderten Signal;
- Filtern des in der Pulsweite veränderten Hochfrequenzsignals zur Unterdrückung von harmonischen Signalanteilen höherer Ordnung im veränderten Hochfrequenzsignal;

wobei der Schritt des Zuführens der Phaseninformation den Schritt eines Veränderns der Phaseninformation in Abhängigkeit der Amplitudeninformation umfasst.

Dadurch erfolgt kein Mischvorgang für die Amplitudenmodulation, sondern das phasenmodulierte Signal wird pulsweitenmoduliert und anschließend gefiltert, um nicht erwünschte Frequenzanteile zu unterdrücken.

Weitere vorteilhafte Ausgestaltungen ergeben sich aus den Unteransprüchen. Im Folgenden wird die Erfindung unter Zuhilfenahme der Zeichnungen im Detail erläutert.

Es zeigen:

Figur 1 eine Ausführungsform des Polarmodulators,

Figur 2A eine Ausgestaltung des Pulsweitenmodulators gemäß dem Ausführungsbeispiel in Figur 1,

Figur 2B eine zweite Ausführungsform des Pulsweitenmodulators,

Figur 3 eine Ausführungsform eines $\Sigma\Delta$-Modulators zur Verarbeitung der zeitlichen Amplitudeninformation,

Figur 4 ein Ausführungsbeispiel einer Verzögerungseinheit,

Figur 5 ein Zeit-Amplitudendiagramm zur Darstellung eines Rechtecksignals,

Figur 6 ein Diagramm zur Darstellung der Abhängigkeit der Amplitude vom Tastverhältnis,

Figur 7 einen bekannten I/Q-Modulator,

Figur 8 einen bekannten Polarmodulator,

Figur 9 ein Konstellationsdiagramm zur Darstellung eines Symbols in I/Q- und Polarschreibweise.

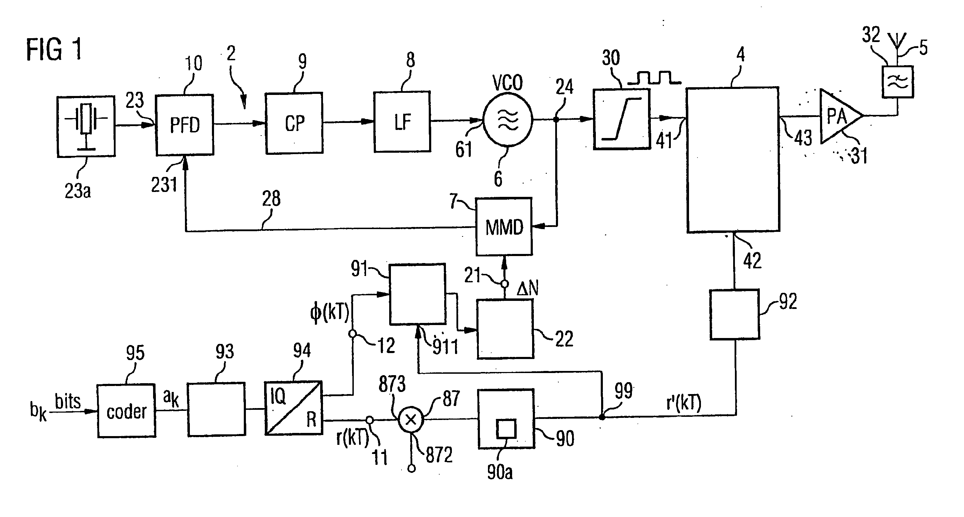

Figur 1 zeigt einen erfindungsgemäßen Polarmodulator, der bevorzugt als integrierte Schaltung in einem Halbleiterkörper integrierbar ist. Auf der Oberfläche des Halbleiterkörpers sind Kontaktstellen angebracht, die der integrierten Schaltung Signale zuführen. Die dabei verwendete Technologie ist abhängig von den Anforderungen unterschiedlich. Beispielsweise kann der erfindungsgemäße Polarmodulator in CMOS-Technologie ausgeführt sein. Als Halbleitermaterial bietet sich Silizium, Galliumarsenid oder Siliziumgermanium (SiGe) an. Natürlich sind auch andere Halbleitermaterialien denkbar.

Die Erfindung schlägt vor, eine Amplitude des zu sendenden Signals in einem Polarmodulator über das Tastverhältnis beziehungsweise die Pulsbreite eines digitalen Signals zu verändern. Dadurch kann auf strom- und platzverbrauchende Schaltelemente wie beispielsweise Mischer und Digital/Analogkonverter verzichtet werden.

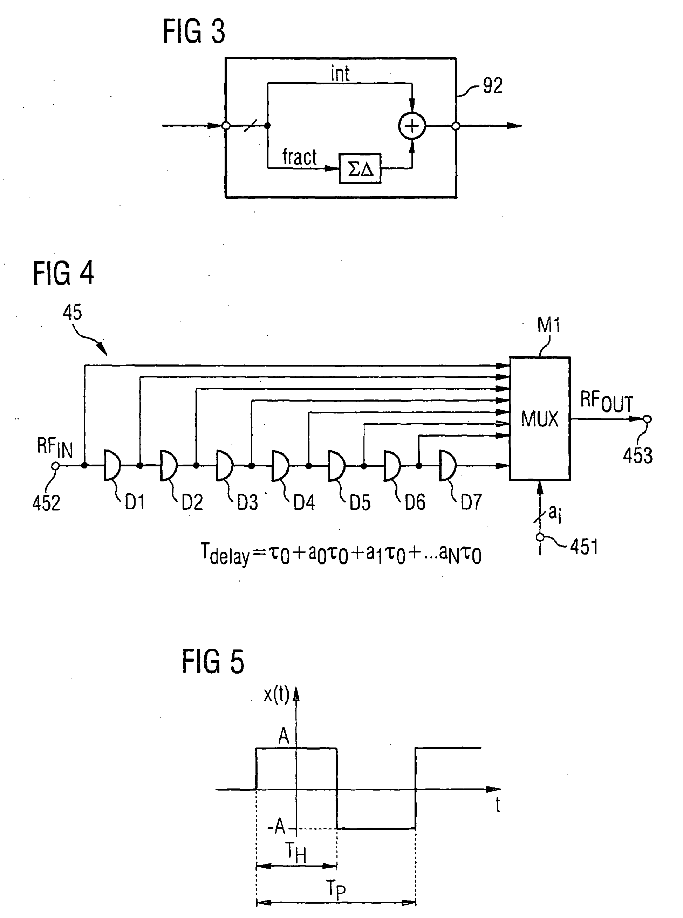

Das Tastverhältnis $\eta$ ist definiert als die Pulsbreite $T_H$ zu der Pulsperiode $T_P$. Dieses Verhältnis ist im Diagramm der Figur 5 gezeigt. Der dort dargestellte Puls weist ein Tastverhältnis von 50 % auf. Damit ist die Pulslänge $T_H$ genau halb so groß wie die gesamte Periode. Es gilt allgemein:

$$\eta = \frac{T_H}{T_P}$$

Im Beispiel der Figur 5 beträgt das Tastverhältnis $\eta$ = 0,5. Rechtecksignale der in Figur 5 dargestellten Art lassen sich mithilfe einer Fourierreihenentwicklung darstellen. Es gilt für ein Rechtecksignal:

$$x(t) = A\,(2\eta - 1) + 4\,A \sum_{n=1}^{\infty} \frac{\sin(n\,\pi\,\eta)}{n\,\pi} \cos(n\,\varpi\,t)$$

Dabei gibt $\eta$ das Tastverhältnis $T_H$ durch Tp an. Bei einem Tastverhältnis von $\eta$ = 0,5, wie in Figur 5 dargestellt, entfällt der erste Term $A(2\eta\text{-}1)$.

Figur 6 zeigt die Abhängigkeit der Amplitude von dem Tastverhältnis für die ersten drei harmonischen Anteile H1, H2, H3 der Reihenentwicklung. Es ist zu erkennen, dass bei einem Tastverhältnis von $\eta$ = 0,5 die Grundschwingung H1, das heißt die erste Harmonische den maximalen Amplitudenwert von ca. A = 0,64 erreicht. Bei einem Tastverhältnis zwischen $\eta$ = 0 und $\eta$ = 0,5 steigt somit die Amplitude von kleinen Werten im Bereich von A = 0 bis auf den Maximalwert von A = 0,64 an. Durch Auswahl des Tastverhältnisses lässt sich so die Amplitude der Grundwelle der Fourierreihenentwicklung festlegen.

Der erfindungsgemäße Polarmodulator nützt dieses Verhalten, um über eine Pulsweitenmodulation des phasenmodulierten Signals die Amplitude des Signals gemäß den Vorgaben der zu übertragenden Signale zu verändern.

Dazu enthält der Polarmodulator gemäß Figur 1 einen Phasenregelkreis 2. Dieser umfasst einen Phasendetektor 10 mit einem Referenzeingang 23, dem ein Referenzsignal von einem Referenzgenerator 23a zugeführt wird. Der Phasendetektor 10 weist weiterhin einen Rückführungseingang 231, dem ein vom Phasenregelkreis rückgeführtes Signal zugeführt wird. Die an den Eingängen 23 und 231 anliegenden Signale werden im Phasendetektor 10 in ihrer Phase verglichen. Abhängig von diesem Vergleich erzeugt der Detektor 10 ein Stellsignal, das über eine Ladungspumpe 9 und ein Schleifenfilter 8 an einen Stelleingang eines spannungsgesteuerten Oszillators 6 angelegt wird. Abhängig von diesem Stellsignal, welches im wesentlichen die Phasendifferenz die an den Eingängen 23 und 231 anliegenden Signale darstellt, verändert der spannungsgesteuerte Oszillator 6 die Frequenz seines Ausgangssignals. Am Ausgang des spannungsgesteuerten Oszillators 6 ist ein Knoten 24 vorgesehen, der mit einem Rückführungspfad 28 verbunden ist.

Der Rückführungspfad 28 enthält einen Frequenzteiler 7 mit einstellbarem Teilerverhältnis. Der Frequenzteiler 7 teilt die Frequenz eines eingangsseitig anliegenden Signals um einen über den Einstelleingang regelbaren Teilerfaktor und führt das frequenzgeteilte Signal dem Rückführungseingang 231 des Phasendetektors 10 zu.

Der Stelleingang 21 ist an einen Sigma-Delta-Modulator 22 angeschlossen, der seinerseits mit einem ersten Signaleingang 12 zur Zuführung eines Phasenmodulationssignals $\phi(kt)$ gekoppelt ist. Der Sigma-Delta-Modulator 22 erzeugt auf dem Phasenmodulationssignal $\phi(kt)$ einen gebrochenen Teilfaktor mit einem ganzzahligen Teilerwert N und einem gebrochenen Teilerwert $\Delta$N. Diesen als digitalen Wert vorliegenden Teilerfaktor übergibt er dem Frequenzteiler 7 zur Einstellung des Teilerverhältnisses.

Zur schnelleren Frequenzeinstellung ist in einer leicht abgewandelten Form der Phasenregelkreis mit einem 2-Punkt-Modulator ausgeführt. Dabei ist der Stelleingang 2 des Regelkreises nicht nur mit dem Stelleingang des Frequenzteilers 7 verbunden, sondern auch mit einem zweiten Regeleingang des Oszillators 8. Bei einer Frequenz bzw. Phasenänderung wird diese sowohl als neues Teilersignal, als auch als zusätzliches Regelsignal dem Oszillator zugeführt. Der Oszillator schwingt so sehr schnell auf der neuen Frequenz, während der Regelkreis ausreichend Zeit hat, sich neu einzustellen.

Ausgangsseitig ist der Phasenregelkreis an einen begrenzenden Verstärker 30 angeschlossen. Dieser erzeugt aus dem von spannungsgesteuerten Oszillator 6 abgegebenen Signal ein Rechtecksignal. Die Phaseninformation bleibt dabei im sogenannten Nulldurchgang des Rechtecksignals erhalten. Der Ausgang des begrenzenden Verstärkers 30 ist an einen Eingang 41 eines Pulsweitenmodulators 4 angeschlossen. Der Pulsweitenmodulator 4 umfasst weiterhin einen Stelleingang 42, der mit dem ersten Signaleingang 11 zur Zuführung des Amplitudenmodulationssignals r(kt) gekoppelt ist. Ausgangsseitig ist der Pulsweitenmodulator 4 an einen Verstärker 31 angeschlossen. Der Ausgang des Verstärkers 31 führt an ein Tiefpassfilter 32 sowie an ein Anpassnetzwerk und an eine Antenne 5.

Im Betrieb wird dem Pulsweitenmodulator 4 an seinem Stelleingang 42 ein Regelsignal zur Modulation der Pulsweite des am Eingang 41 anliegenden Signals zugeführt. Der Pulsweitenmodulator verändert das Tastverhältnis des eingangsseitigen anliegenden rechtecksförmigen und bereits phasenmodulierten Signals und gibt dieses an seinem Ausgang 43 ab. Wie bereits zu der Figur 6 erläutert, stellt das vom Pulsweitenmodulator 4 abgegebene rechtecksförmige Signal mit einem bestimmten Tastverhältnis eine Überlagerung einer Vielzahl harmonischer Wellen dar. Der Verstärker 31 enthält ein Tiefpassfilter, das die höher harmonischen Frequenzanteile aus dem Rechtecksignal herausfiltert. Somit werden die Frequenzanteile der zweiten Harmonischen H2, also der ersten Oberschwingung und aller folgenden Harmonischen H3 unterdrückt und nur die Grundschwingung H1 gelangt in einen nachgeschalteten Verstärker 31 und das Anpassnetzwerk 32. Die Amplitude der Grundschwingung H1 ist wiederum abhängig von dem Tastverhältnis, welches durch den Pulsweitenmodulator vorgegeben ist. Gleichzeitig besitzt die Grundschwingung die gleich Phaseninformation wie das am Eingang des Modulators 4 anliegende Signal. Insgesamt wird so eine Amplitudenmodulation des bereits phasenmodulierten und vom Phasenregelkreis abgegebenen Signals durch eine Pulsweitenmodulation mit anschließender Filterung durchgeführt.

Ein zusätzlicher Aspekt ist das nichtlineare Übertragungsverhalten der Grundschwingung H1, die in Figur 6 durch die-einfache Sinushalbwelle dargestellt ist. Im Bereich des Tastverhältnisses von 0 bis 0,5 ist die dargestellte Grundschwingung H1 nicht linear. Um daher ein lineares Übertragungsverhalten des Polarmodulators bei einer Amplitudenmodulation mithilfe der Pulsweitenmodulation zu gewährleisten, ist es zweckmäßig, das digitale Amplitudenmodulationssignal geeignet vor zu verzerren. Dadurch wird eine Pulsweitenmodulation mit einem vorverzerrten digitalen Amplitudenmodulationssignal durchgeführt, wodurch die dargestellte Nichtlinearität im Ausgangssignal kompensiert wird.

Signaltechnisch ist eine solche Kompensation durch eine geeignete Vorverzerrung mit der Umkehrfunktion der zu verzerrenden Funktion erreichbar. Eine Vorverzerrung stellt gemäß der Darstellung in Figur 6 die inverse Funktion des zu verzerrenden Signals dar. Da im vorliegenden Ausführungsbeispiel die zu verzerrende Funktion durch eine Sinusfunktion gebildet wird, ist eine geeignete Kompensation durch die inverse Sinusfunktion erreichbar.

Dem Eingang 11 zur Zuführung des Amplitudenmodulationssignals r(kT) ist somit eine Vorverzerrungseinheit 90 nachgeschaltet. Diese enthält eine Tabelle 90a, in der die Werte für die inverse Sinusfunktion in Abhängigkeit verschiedener Tastverhältnisse abgelegt sind. Ein eingangsseitig angelegtes Amplitudenmodulationssignal wird so mit einem Wert der inversen Signalübertragungsfunktion multipliziert. Dadurch wird der Wert des Amplitudenmodulationssignals abhängig von seinem eigenen Wert verändert. Das Ergebnis wird als digitaler Wert einem Sigma-Delta-Modulator 92 zugeführt. Dieser erzeugt daraus durch Überabtastung ein Regelsignal, und legt dieses am Eingang 42 einer Synchronisationseinheit an, die Teil des Pulsweitenmodulators 4 ist. Das überabgetastete Regelsignal erlaubte eine Reduzierung des Quantisierungsrauschens beziehungsweise eine besonders genaue Einstellung der Pulsweitenmodulation im Pulsweitenmodulator 4.

Durch die Pulsweitenmodulation, also der Änderung des Tastverhältnisses wird auch die Phase des vom Phasenregelkreis 2 abgegebenen Signals verändert. Es ist daher notwendig, abhängig von dem Amplitudenmodulationssignal r(kt) eine Phase zu verändern, um diesen Effekt zu kompensieren. Daher ist zwischen dem ersten Signaleingang 12 zur Zuführung des Phasenmodulationssignals $\phi$(kt) und dem Sigma-Delta-Modulator 22, der daraus das Stellsignal zur Einstellung des Frequenzteilerverhältnisses erzeugt, ein Phasenverzögerungsglied 91 geschaltet. Dieses enthält einen Stelleingang 911, der mit dem Knoten 99 verbunden ist. Dem Phasenverzögerungsglied 91 wird so ein vorverzerrtes Amplitudenmodulationssignal zugeführt. Das Phasenmodulationssignal $\phi$(kt) wird von der Phasenanpassungseinheit 91 derart verändert, dass die spätere Pulsweitenmodulation diesen Phasenversatz wieder kompensiert.

Der in Figur 1 dargestellte Polarmodulator ist mit seinem ersten und seinem zweiten Signaleingang an eine Schaltung 94 angeschlossen, die aus den zu übertragenden Daten $a_K$ die zu übertragenden Amplituden und Phaseninformation erzeugt und das Phasenmodulations- beziehungsweise Amplitudenmodulationssignal den Eingängen 12 und 11 zuführt.

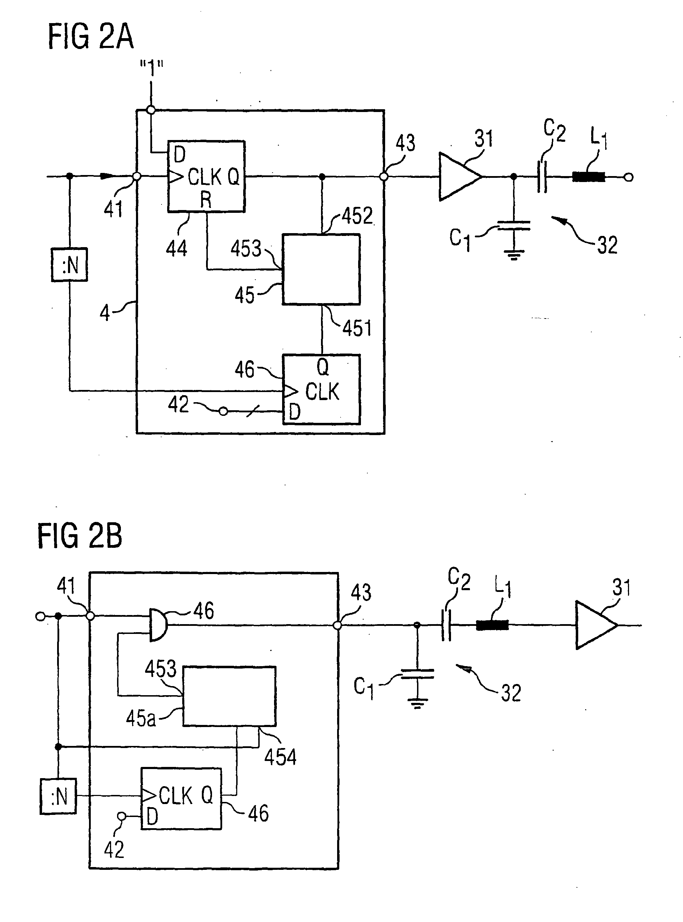

Figur 2A zeigt eine erste Ausführungsform des Pulsweitenmodulators 4 wie er in dem erfindungsgemäßen Polarmodulator eingesetzt ist. Wirkungs- beziehungsweise funktionsgleiche Bauelemente tragen dabei die gleichen Bezugszeichen. Bei dem dargestellten Ausführungsbeispiel des Pulsweitenmodulators wird berücksichtigt, dass das Amplitudenmodulationssignal möglichst synchron zu dem entsprechenden phasenmodulierten Trägersignal am Eingang 41 des Pulsweitenmodulators 4 sein muss, damit keine Übertragungsfehler im Nutzsignal erzeugt werden.

Daher enthält der Pulsweitenmodulator 4 auch eine Synchronisationseinheit aus einem Frequenzteiler, der eingangsseitig an den Eingang 41 angeschlossen ist, und der ein frequenzgeteiltes Signal einem Takteingang einer Flip-Flopschaltung 46 zuführt. Der Dateneingang D des Flip-Flops 46 bildet den Stelleingang 42 des Pulsweitenmodulators 4.

Der Eingang 41 des Pulsweitenmodulators 4 ist außerdem an den Takteingang CLK einer Flip-Flop-Schaltung 44 angeschlossen. Der Dateneingang des Flip-Flops 44 führt an einen weiteren Eingang des Pulsweitenmodulators 4. Diesem Eingang wird immer ein Signal mit einem logisch hohen Pegel, einer logischen 1 zugeführt. Der Datenausgang Q des Flip-Flops 44 ist mit dem Ausgang 43 des Pulsweitenmodulators 4 verbunden.

Weiterhin enthält der Pulsweitenmodulator 4 eine Verzögerungsschaltung 45, die mit einem Ausgang 453 an den Rücksetzeingang des Flip-Flops 44 angeschlossen ist. Die Verzögerungsschaltung 45 enthält einen Eingang 452, welcher mit dem Datenausgang Q des Flip-Flop 44 verbunden ist. Ein Regeleingang 451 zur Regelung der Verzögerung führt an den Datenausgang Q des Flip-Flops 46, wodurch die Verzögerung synchronisiert wird. In dieser Ausführungsform wird das D-Flip-Flop 44 durch ein Signal am Rücksetzeingang zurückgesetzt und erzeugt dadurch an seinem Datenausgang Q ein Signal mit einem logisch niedrigen Pegel. Jede steigende Taktflanke am Takteingang CLK erzeugt am Datenausgang Q eine steigende Taktflanke im Ausgangssignal. Die steigende Taktflanke wird durch die Verzögerungseinheit 45 gemäß der Vorgabe des Amplitudenmodulationssignals um einen gewissen Wert verzögert und erst dann dem Rücksetzeingang R des Flip-Flops 44 zugeführt. Dadurch werden die Pulsbreiten der Pulse am Takteingang CLK verändert erzeugt. Ausgangsseitig wird das Signal in einem Verstärker 31 verstärkt und über ein Anpassnetzwerk 32 abgegeben. Das Anpassnetzwerk 32 dient gleichzeitig als Tiefpassfilter mit einer Grenzfrequenz zwischen der Frequenz der Grundschwingung und der Frequenz der zweiten Harmonischen. Durch die Phasen- und Amplitudenvorverzerrung bleibt die Linearität erhalten. An eine nachgeschaltete Antenne, wie in Figur 1, gelangt nur die Grundschwingung.

Eine alternative Ausführungsform eines Pulsweitenmodulators zeigt Figur 2B. Der Pulsweitenmodulator 4 enthält hier neben der Synchronisationseinheit ein logisches UND-Gatter 46 mit einem ersten und einem zweiten Eingang. Der erste Eingang bildet den Signaleingang 41 des Pulsweitenmodulators 4. Der zweite Eingang des logischen UND-Gatters ist an den Ausgang 453 einer Verzögerungsschaltung 45a angeschlossen. Die Verzögerungsschaltung 45a umfasst einen Regeleingang, der den Datenausgang des Flip-Flops 46 angeschlossen ist. Die Verzögerungsschaltung 45a dient zur Abgabe eines zeitlich verzögerten Pulssignals am Ausgang 453 aus dem Trägersignal, das an einem zweiten Eingang 454 zugeführt wird.

Dadurch schaltet das logische UND-Gatter 46 bei gleichzeitig hohem Pegel im Signal am ersten Eingang des Gatters auf einen logisch hohen Zustand und gibt diesen am Ausgang 43 ab. Somit wird am Ausgang 43 ein pulsweitenmoduliertes Signal erzeugt, wobei das Tastverhältnis über ein Regelsignal am Stelleingang 42 eingestellt ist. Das pulsweitenmodulierte Signal enthält wie bereits oben erläutert die Frequenzanteile einer Grundschwingung und der dazugehörigen harmonischen Schwingungen. Die harmonischen Anteile werden von der Filtereinrichtung 32 unterdrückt und gelangen dann in dem dem Filter nachgeschalteten Verstärker 31. Dadurch verstärkt der Verstärker 31 ein bereits gefiltertes Signal.

Figur 3 zeigt eine Ausführung eines Modulators 92, der dem Stelleingang 42 des Pulsweitenmodulators 4 vorangeschaltet ist. Der Modulator 92 umfasst einen ersten und einen zweiten Signalpfad, wobei dem ersten Signalpfad ein ganzzahliger Anteil "int" des Amplitudenmodulationssignals zugeführt wird und der zweite Signalpfad zur Verarbeitung des gebrochenen Anteils "fract" ausgeführt ist. Dazu enthält der zweite Signalpfad einen $\Sigma\Delta$-Modulator (Sigma-Delta-Modulator). Ausgangsseitig werden der ganzzahlige Anteil und ein modulierter gebrochener Anteil zusammengeführt.

Figur 4 zeigt eine Ausgestaltungsform der Verzögerungsschaltung 45. Auch hier tragen wirkungs- beziehungsweise funktionsgleiche Bauelemente die gleichen Bezugszeichen. Der Signaleingang 452 der Verzögerungsschaltung 45 ist über mehrere einzelne Verzögerungsglieder D1, D2 bis D7 an einen Multiplexer M1 angeschlossen. Durch die einzelnen Verzögerungsglieder D1 bis D7 wird ein Pulssignal am Eingang 452 um jeweils einen festen Zeitversatz $\tau_0$ verzögert. Der Multiplexer gibt abhängig von einem Regelsignal am Stelleingang 451 somit einen der zeitlich verzögerten Impuls am Ausgang 453 ab. Die zeitliche Verzögerung wird von dem Regelsignal am Stelleingang 451 vorgegeben, die wiederum mit dem phasenmodulierten Signal synchronisiert ist.

Mit der erfindungsgemäßen Ausgestaltungsform des Polarmodulators wird, anstatt einer stromverbrauchenden Mischerschaltung, eine reine digitale Schaltung verwendet, die bevorzugt und effizient in einem Halbleiterkörper als integrierte Schaltung ausgebildet ist. Die Amplitudenmodulation wird dabei über eine Pulsbreitenmodulation mit nachgeschalteter Filterung der höheren harmonischen Anteile durchgeführt. Aufgrund der Pulsweitenmodulation ändert sich das Tastverhältnis und eine Phasenanpassung wird erforderlich, um eine Amplituden/Phasenverzerrung zu verhindern. Die Phasenverzerrung wird bevorzugt durch eine geeignete Phasenanpassungsschaltung im digitalen Bereich durch Änderung des Phasenmodulationswort durchgeführt. Diese erfolgt dahingehend, dass der Nulldurchgang der Trägerfrequenz in Abhängigkeit der Amplitudeninformation verändert wird. Die weiterhin im Amplitudenmodulationspfad vorgesehene Vorverzerrungsschaltung kompensiert die sinusförmige Abhängigkeit des Ausgangssignals vom Tastverhältnis.

Bezugszeichenliste

| | |
|---|---|
| 2: | Phasenregelkreis |
| 4: | Pulsweitenmodulator |
| 5: | Antenne |
| 6: | spannungsgesteuerter Oszillator |
| 7: | Frequenzteiler |
| 8: | Schleifenfilter |
| 9: | Ladungspumpe |
| 10: | Phasendetektor |
| 11: | Amplitudeninformationseingang |
| 12: | Phasenmodulationseingang |
| 21: | Stelleingang |
| 22: | Sigma-Delta-Modulator |
| 23: | Referenzeingang |
| 23a: | Referenzgenerator |
| 24: | Knoten, Ausgangsknoten |
| 28: | Rückführungspfad |
| 30: | begrenzender Verstärker |
| 31: | Verstärker |
| 32: | Anpassnetzwerk, Tiefpassfilter |
| 41: | Signaleingang |
| 42: | Stelleingang |
| 43: | Signalausgang |
| 90: | Vorverzerrungseinheit |
| 91: | Phasenanpassungseinheit |
| 92: | Sigma-Delta-Modulator |
| 87: | Skaliereinheit |
| 872: | Skaliersignaleingang |
| 873: | Signaleingang |
| D1, ..., D6, D7: | Verzögerungsglieder |
| 44: | Flip-Flop |
| 45, 45a: | Verzögerungseinheit |
| 46: | UND-Gatter |
| $\eta$: | Tastverhältnis |
| H1, H2, H3: | Grundschwingung, Harmonische |

**Patentansprüche**

1. Polarmodulator, umfassend:

• einen ersten Signaleingang (12) zur Zuführung eines Phasenmodulationssignals ($\Phi$) und einen zweiten Signaleingang (11) zur Zuführung eines Amplitudenmodulationssignals (r);
• einen Phasenregelkreis (2) mit einem Referenzeingang (23) zur Zuführung eines Referenzsignals und mit einem Stelleingang (21), der mit dem ersten Signaleingang (12) gekoppelt ist, der Phasenregelkreis (2) ausgebildet zur Abgabe eines Hochfrequenzsignals mit einer Frequenz an einen Ausgangsknoten (24), wobei die Frequenz aus dem Referenzsignal und dem Phasenmodulationssignals ($\Phi$) am Stelleingang des Phasenregelkreises (2) abgeleitet ist;
• einen Pulsweitenmodulator (4), mit einem Signaleingang (41) und mit einem Stelleingang (42), der Pulsweitenmodulator (4) ausgebildet zu einer über ein Regelsignal am Stelleingang (42) einstellbaren Veränderung eines Tastverhältnisses eines am Signaleingang (41) anliegenden pulsförmigen Signals,

• ein einem Ausgang (43) des Pulsweitenmodulators (4) nachgeschaltetes Filter (32) zur Unterdrückung harmonischer Anteile eines am Ausgang (43) des Pulsweitenmodulators (4) abgreifbaren Signals,
• wobei der Signaleingang (41) des Pulsweitenmodulators (4) mit dem Ausgangsknoten (24) des Phasenregelkreises (2) zur Zuführung des vom Phasenregelkreis (2) phasenmodulierten und pulsförmigen Hochfrequenzsignals und der Stelleingang (42) mit dem zweiten Signaleingang (11) gekoppelt ist,

**dadurch gekennzeichnet, dass**
dem ersten Signaleingang (12) eine Anpassschaltung (91) nachgeschaltet ist, die einen mit dem zweiten Signaleingang (11) gekoppelten Regeleingang (911) umfasst und ausgeführt ist, abhängig von einem Signal am Regeleingang das dem ersten Signaleingang zugeführte Phasenmodulationssignal zu verändern.

2.  Polarmodulator nach Anspruch 1,
    bei dem zwischen Ausgangknoten (24) des Phasenregelkreises (2) und dem Signaleingang (41) des Pulsweitenmodulators (4) eine Verstärkerschaltung (30) vorgesehen ist, die ein begrenzendes Verstärkungsverhalten aufweist.

3.  Polarmodulator nach einem der Ansprüche 1 bis 2,
    bei dem der Pulsweitenmodulator (4) ein Flip-Flop (44) aufweist, dessen Takteingang (CLK) den Signaleingang (41) des Pulsweitenmodulators (4) bildet, dessen Datenausgang (Q) an den Ausgang (43) des Pulsweitenmodulator (4) angeschlossen ist und dessen Rücksetzeingang (R) ein von dem am Stelleingang anliegenden Regelsignal abgeleitetes Pulssignal zuführbar ist.

4.  Polarmodulator nach einem der Ansprüche 1 bis 3,
    bei dem der Pulsweitenmodulator (4) ein logisches Gatter (46) umfasst, dessen erster Eingang an den Signaleingang (41) des Pulsweitenmodulators (4) angeschlossen ist, dessen Datenausgang an den Ausgang (43) des Pulsweitenmodulator (4) angeschlossen ist und dessen zweitem Eingang ein von dem am Stelleingang (42) anliegenden Regelsignal abgeleitetes Pulssignal zuführbar ist.

5.  Polarmodulator nach Anspruch 4,
    bei dem das logische Gatter (46) als ein UND-Gatter ausgeführt ist.

6.  Polarmodulator nach einem der Ansprüche 3 bis 5,
    bei dem der Pulsweitenmodulator (4) eine Verzögerungseinheit (45, 45a) umfasst, die zur einer zeitlich steuerbaren Abgabe eines Pulssignals an einen Ausgang (453) ausgeführt ist, wobei der Ausgang (453) mit dem zweiten Eingang des logischen Gatters (46) oder dem Rücksetzeingang (R) des Flip-Flops (44) verbunden ist.

7.  Polarmodulator nach Anspruch 6,
    bei dem die Verzögerungseinheit (45) zumindest zwei in Reihe geschaltete Verzögerungsglieder (D1, D2) aufweist, die eingangsseitig zur Zuführung eines gepulsten Signals ausgebildet sind, die ausgangsseitig an jeweils einen von zumindest zwei Eingängen einer Multiplexereinheit angeschlossen sind, die ausgeführt ist, abhängig von dem Regelsignal am Stelleingang (42) einen Eingang der zumindest zwei Eingänge der Multiplexereinheit auf den Ausgang (453) zu schalten.

8.  Polarmodulator nach Anspruch 7,
    bei dem die Verzögerungseinheit (45) eingangsseitig mit dem Ausgang (43) des Pulsweitenmodulators (4) gekoppelt ist.

9.  Polarmodulator nach einem der Ansprüche 1 bis 8,
    bei dem der Phasenregelkreis (2) einen Frequenzteiler (7) in einem Rückführungspfad (28) umfasst, der ausgebildet ist, ein eingangsseitig anliegendes Signal in seiner Frequenz um einen einstellbaren Teilerfaktor zu teilen, und der einen mit dem ersten Signaleingang (12) verbundenen Einstelleingang zur Einstellung des Teilerfaktors aufweist.

10. Polarmodulator nach Anspruch 9,
    bei dem dem Einstelleingang des Frequenzteilers (7) ein Sigma-Delta-Frequenzteiler (22) vorgeschaltet ist, der eingangsseitig mit dem ersten Signaleingang (12) gekoppelt ist.

11. Polarmodulator nach einem der Ansprüche 1 bis 10,
    bei dem der Phasenregelkreis (2) mit einem 2-Punkt-Modulator ausgebildet ist.

**12.** Polarmodulator nach einem der Ansprüche 1 bis 11,
bei dem dem Regeleingang (42) des Pulsweitenmodulators (4) eine
Multiplikationseinheit (87) vorgeschaltet ist, die zur Skalierung des Amplitudenmodulationssignals an einem ersten Eingang (873) der Multiplikationseinheit (87) mit einem Skalierungsfaktor ausgebildet ist, der einem zweiten Eingang (872) zuführbar ist.

**13.** Polarmodulator nach einem der Ansprüche 1 bis 12,
bei dem dem Stelleingang (42) des
Pulsweitenmodulators (4) eine Verzerrungseinheit (90) vorgeschaltet ist, deren Eingang an den zweiten Signaleingang (11) des Polarmodulators angeschlossen ist, und die ausgebildet ist, ein eingangsseitig anliegendes Signals amplitudenabhängig mit Vorverzerrungskoeffizienten zu beaufschlagen.

**14.** Polarmodulator nach Anspruch 13,
bei dem die Verzerrungseinheit (90) eine Tabelle (90a) enthält, in der die Vorverzerrungskoeffizienten abgelegt sind.

**15.** Polarmodulator nach einem der Ansprüche 13 bis 14,
bei dem die Vorverzerrungskoeffizienten eine Umkehrfunktion einer trigonometrischen Funktion darstellen.

**16.** Verfahren zur Modulation eines Signals umfassend:

• Bereitstellen eines Phasenregelkreises (2) mit einem einstellbaren Frequenzteilerverhältnisses in einem Rückführungspfad (28) des Phasenregelkreises (2);
• Bereitstellen einer Phaseninformation (Φ) und einer Amplitudeninformation (r) für eine Signalmodulation;
• Zuführen der Phaseninformation (Φ) an den Phasenregelkreis (2) und Einstellen des Frequenzteilerverhältnisses in Abhängigkeit der Phaseninformation (Φ);
• ein Erzeugen eines phasenmodulierten pulsförmigen Hochfrequenzsignals in Abhängigkeit des eingestellten Frequenzteilerverhältnisses;
• Verändern der Pulsweite des phasenmodulierten pulsförmigen Hochfrequenzsignals in Abhängigkeit der Amplitudeninformation (r);
• Filtern des in der Pulsweite veränderten Hochfrequenzsignals zur Unterdrückung von harmonischen Signalanteilen höherer Ordnung im veränderten Hochfrequenzsignal;

**dadurch gekennzeichnet, dass**
der Schritt des Zuführens der Phaseninformation (Φ) den Schritt eines Veränderns der Phaseninformation (Φ) in Abhängigkeit der Amplitudeninformation (r) umfasst.

**Claims**

**1.** A polar modulator, comprising:

• a first signal input (12) for supplying a phase modulation signal (Φ) and a second signal input (11) for supplying an amplitude modulation signal (r);
• a phase locked loop (2) having a reference input (23) for supplying a reference signal and a control input (21), which is coupled to the first signal input (12), the phase locked loop (2) being configured to output a high-frequency signal at one frequency at an output node (24), wherein the frequency is derived from the reference signal and from the phase modulation signal (Φ) at the control input of the phase locked loop (2);
• a pulse width modulator (4) having a signal input (41) and a control input (42), the pulse width modulator (4) being configured to a settable variation of a duty ratio of a pulse-shape signal applied to the signal input according to a regulation signal at the control input (42),
• a filter (32) arranged downstream from an output (43) of the pulse width modulator (4) for suppression of harmonic components of the phase-amplitude modulated signal which can be tapped at the output (43) of the pulse width modulator (4),
• wherein the signal input (41) of the pulse width modulator (4) is coupled to the output node (24) of the phase locked loop (2) for supplying the pulse-shape high-frequency signal being phase modulated by the phase locked loop (2), and wherein the control input (42) is coupled to the second signal input (11),

**characterized in that**

• a matching circuit (91) is coupled downstream from the first signal input (12), which matching circuit (91) comprises a control input (911) coupled to the second signal input (11) and is configured to vary the phase modulation signal supplied to the first signal input dependent from a signal at the control input.

**2.** The polar modulator of claim 1,
in which an amplifier circuit (30), which has a limiting gain response, is provided between output node (24) of the phase locked loop (2) and the signal input (41) of the pulse width modulator (4).

**3.** The polar modulator of any one of claims 1 to 2,
in which the pulse width modulator (4) comprises a flipflop (44), the clock input (CLK) of which forms the signal input (41) of the pulse width modulator (4), the data output (Q) of which is coupled to the output (43) of the pulse width modulator (4), and the reset input (R) of which can be supplied with a pulsed signal derived from the regulation signal at the control input.

**4.** The polar modulator of any one of claims 1 to 3,
in which the pulse width modulator (4) comprises a logic gate (46), the first input of which is coupled to the signal input (41) of the pulse width modulator (4), the data output of which is coupled to the output (43) of the pulse width modulator (4), and the second input of which can be supplied with a pulsed signal derived from the regulation signal at the control input (42).

**5.** The polar modulator of claim 4,
in which the logic gate (46) is configured as an AND gate.

**6.** The polar modulator of any one of claims 3 to 5,
in which the pulse width modulator (4) comprises a delay unit (45, 45a) which is configured for a timely controlled output of a pulse signal at an output (453), wherein the output (453) is coupled to the second input of the logic gate (46) or to the reset input (R) of the flipflop (44).

**7.** The polar modulator of claim 6,
in which the delay unit (45) comprises at least two series connected delay elements (D1, D2), which are configured at their input sides for the supply of a pulsed signal, which are coupled at their output sides at respectively one of at least two inputs of a multiplexer unit, which is configured to connect an input of the at least two inputs of the multiplexer unit to the output (453) dependent from the regulation signal at the control input (42).

**8.** The polar modulator of claim 7,
in which the delay unit (45) is coupled at its input side to the output (43) of the pulse width modulator (4).

**9.** The polar modulator of any one of claims 1 to 8,
in which the phase locked loop (2) comprises a frequency divider (7) in a feedback path (28) that is configured to divide a frequency of the signal applied to its input side by a variable division factor, and comprises an adjustment input connected to the first signal input for adjustment of the division factor.

**10.** The polar modulator of claim 9,
in which a sigma-delta frequency divider (22) is connected upstream of the adjustment input of the frequency divider (7) and having an input side coupled to the first signal input (12).

**11.** The polar modulator of any one of claims 1 to 10,
in which the phase locked loop (2) comprises a two-point modulator.

**12.** The polar modulator of any one of claims 1 to 11,
in which a multiplication unit (87) is connected upstream of the control input (42) of the pulse width modulator (4), which multiplication unit is configured for the scaling of the amplitude modulation signal at a first input (873) of the multiplication unit (87) by a scaling factor, which can be supplied to a second input (872).

**13.** The polar modulator of any one of claims 1 to 12,
in which a distortion unit (90) is connected upstream of the control input (42) of the pulse width modulator (4), the input of which is connected to the second signal input (11) of the polar modulator, and which is configured to load the signal applied at its input side amplitude dependent with pre-distortion coefficients.

**EP 1 672 862 B1**

**14.** The polar modulator of claim 13,
in which the distortion unit (90) comprises a table (90a), in which the pre-distortion coefficients are stored.

**15.** The polar modulator of any one of claims 13 to 14,
in which the pre-distortion coefficients represent a reciprocal function of a trigonometric function.

**16.** A method for modulation of a signal, comprising:

• providing a phase locked loop (2) with a variable frequency division ratio in a feedback path (28) of the phase locked loop (2);
• providing a phase information (Φ) and an amplitude information (r) for a signal modulation;
• supplying the phase information (Φ) to the phase locked loop (2) and adjusting the frequency division ratio as a function of the phase information (Φ);
• a producing of a phase-modulated pulse-shape high-frequency signal as a function of an adjusted frequency division ratio;
• varying the pulse width of the phase-modulated pulse-shape high-frequency signal as a function of the amplitude information (r);
• filtering the high-frequency signal varied in pulse-width to suppress higher order harmonic signal components in the changed high-frequency signal;

**characterized in that**
the step of the supplying the phase information (Φ) comprises the step of changing the phase information (Φ) as a function of the amplitude information (r).

**Revendications**

**1.** Modulateur polaire comprenant :

• une première entrée (12) de signal pour amener un signal (Φ) de modulation de phase et une deuxième entrée (11) de signal pour amener un signal (r) de modulation d'amplitude ;
• un circuit (2) de régulation de phase ayant une entrée (23) de référence pour amener un signal de référence et une entrée (21) de régulation, qui est couplée à la première entrée (12) de signal, le circuit (2) de régulation de phase étant formé pour émettre un signal de haute fréquence ayant une fréquence sur un noeud (24) de sortie, la fréquence étant déduite du signal de référence et du signal (Φ) de modulation de phase à l'entrée de régulation du circuit (2) de régulation de phase ;
• un modulateur (4) d'impulsion en largeur ayant une entrée (41) du signal et une entrée (42) de régulation, le modulateur (4) d'impulsion en largeur étant formé pour une modification, réglable par un signal de régulation à l'entrée (42) de régulation, d'un rapport cyclique d'un signal pulsé s'appliquant à l'entrée (41) du signal :
• un filtre (32) monté en aval de la sortie (43) du modulateur (4) d'impulsion en largeur pour supprimer des harmoniques d'un signal pouvant être prélevé à la sortie (43) du modulateur (4) d'impulsion en largeur ;
• dans lequel l'entrée (41) de signal du modulateur (4) d'impulsion en largeur est couplé au noeud (24) de sortie du circuit (2) de régulation de phase pour amener le signal de haute fréquence pulsé et modulé en phase par le circuit (2) de régulation, de phase et l'entrée (2) de régulation est couplée à la deuxième entrée (11) du signal,

**caractérisé en ce que**
il est monté, en aval de la première entrée (12) du signal, un circuit (91) d'adaptation, qui comprend une entrée (911) de régulation couplée à la deuxième entrée (11) du signal et qui est réalisé pour, en fonction d'un signal sur l'entrée de régulation, modifier le signal de modulation de phase envoyé à la première entrée du signal.

**2.** Modulateur polaire suivant la revendication 1,
dans lequel il est prévu, entre des noeuds (24) de sortie du circuit (2) de régulation de phase et l'entrée (41) du signal du modulateur (4) d'impulsion en largeur, un circuit (30) amplificateur qui a un comportement d'amplification limitant.

**3.** Modulateur polaire suivant l'une des revendications 1 à 2,
dans lequel le modulateur (4) d'impulsion en largeur comporte une bascule (44) dont l'entrée (CLK) d'horloge forme l'entrée (41) du signal du modulateur (4) d'impulsion en largeur, dont la sortie (Q) de donnée est reliée à la sortie (43) du modulateur (4) d'impulsion en largeur et à l'entrée (R) de remise à l'état initial de laquelle peut être envoyé un signal d'impulsion dérivé du signal de régulation appliqué à l'entrée de régulation.

4. Modulateur polaire suivant l'une des revendications 1 à 3, dans lequel le modulateur (4) d'impulsion en largeur comprend une porte (46) logique dont la première entrée est reliée à l'entrée (41) du signal du modulateur (4) d'impulsion en largeur, dont la sortie de donnée est reliée à la sortie (43) du modulateur (4) d'impulsion en largeur et à la deuxième entrée de laquelle peut être envoyé un signal d'impulsion dérivé du signal de régulation s'appliquant à l'entrée (42) de régulation.

5. Modulateur polaire suivant la revendication 4, dans lequel la porte (46) logique est réalisée sous la forme d'une porte ET.

6. Modulateur polaire suivant l'une des revendications 3 à 5, dans lequel le modulateur (4) d'impulsion en largeur comprend une unité (45, 45a) de temporisation, qui est réalisée pour l'émission, pouvant être commandée dans le temps, d'un signal d'impulsion sur une sortie (453), la sortie (453) étant reliée à la deuxième entrée de la porte (46) logique ou à l'entrée (R) de remise à l'état initial de la bascule (44).

7. Modulateur polaire suivant la revendication 6, dans lequel l'unité (45) de temporisation a au moins deux éléments (D1 D2) de temporisation montés en série, qui sont constitués du côté de l'entrée pour l'envoi d'un signal pulsé, qui sont raccordés du côté de la sortie à l'une d'au moins deux entrées d'une unité de multiplexage, laquelle est réalisée pour, indépendamment du signal de régulation à l'entrée (42) de régulation, connecter une entrée des au moins deux entrées de l'unité de multiplexage à la sortie (453).

8. Modulateur polaire suivant la revendication 7, dans lequel l'unité (45) de temporisation est couplée du côté de l'entrée à la sortie (43) du modulateur (4) d'impulsion en largeur.

9. Modulateur polaire suivant l'une des revendications 1 à 8, dans lequel le circuit (2) de régulation de phase comprend un diviseur (7) de fréquence dans un trajet (28) de réaction, qui est constitué pour diviser la fréquence d'un signal s'appliquant du côté de l'entrée par un facteur de division réglable et qui a, pour régler le facteur de division, une entrée de réglage reliée la première entrée (12) du signal.

10. Modulateur polaire suivant la revendication 9, dans lequel un diviseur (22)de fréquence sigma-delta, qui est couplé de l'entrée à la première entrée (12) du signal, est monté en amont de l'entrée de régulation du diviseur (7) de fréquence.

11. Modulateur polaire suivant l'une des revendications 1 à 10, dans lequel le circuit (2) de régulation de phase est constitué en ayant un modulateur à 2 points.

12. Modulateur polaire suivant l'une des revendications 1 à 11, dans lequel il est monté, en amont de l'entrée (42) de régulation du modulateur (4) d'impulsion en largeur, une unité (87) de multiplication, qui est constituée pour mettre à l'échelle le signal de modulation d'amplitude sur une première entrée (873) de l'unité (87) de multiplication par un facteur de mise à l'échelle qui peut être envoyé à une deuxième entrée (872).

13. Modulateur polaire suivant l'une des revendications 1 à 12, dans lequel il est monté, en amont de l'entrée (42) de régulation du modulateur (4) d'impulsion en largeur, une unité (90) de déformation, dont l'entrée est reliée à la deuxième entrée (11) du signal du modulateur polaire et qui est constituée pour soumettre un signal, s'appliquant du côté de l'entrée, en fonction de l'amplitude à des coefficients de prédéformation.

14. Modulateur polaire suivant la revendication 13, dans lequel l'unité (90) de déformation contient une table (90a) dans laquelle les coefficients de prédéformation sont mis.

15. Modulateur polaire suivant l'une des revendications 13 à 14, dans lequel les coefficients de prédéformation représentent une fonction inverse d'une fonction trigonométrique.

16. Procédé de modulation d'un signal dans lequel :

   • on se procure un circuit (2) de régulation de phase ayant un rapport réglable de division de fréquence dans un trajet (28) de réaction du circuit (2) de régulation de phase ;

• on se procure une information (Φ) de phase ayant une information (r) d'amplitude pour une modulation du signal ;

• on envoie l'information (Φ) de phase au circuit (2) de régulation de phase et on règle le rapport de division de fréquence en fonction de l'information (Φ) de phase ;

• on produit un signal de haute fréquence pulsé et modulé en phase en fonction du rapport de division de fréquence réglée ;

• on modifie la largeur d'impulsion du signal de haute fréquence pulsé et modulé en phase en fonction de l'information (r) d'amplitude ;

• on filtre le signal de haute fréquence modifié en largeur d'impulsion pour supprimer des harmoniques du signal d'ordre supérieur dans le signal de haute fréquence modifié ;

**caractérisé en ce que**

le stade d'envoi de l'information (Φ) de phase comprend le stade d'une modification de l'information (Φ) de phase en fonction de l'information (r) d'amplitude.

FIG 1

EP 1 672 862 B1

FIG 2A

FIG 2B

# FIG 3

# FIG 4

$$T_{delay} = \tau_0 + a_0\tau_0 + a_1\tau_0 + \ldots a_N\tau_0$$

# FIG 5

## FIG 6

H1
H2
H3

## FIG 7

# FIG 8

$a_k = r*\exp(j\phi)$

# FIG 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20030112063 A1
- EP 0998088 A2